# EUROPEAN PATENT APPLICATION

(11) **EP 4 712 754 A1**
(43) Date of publication of application: **18.03.2026**
(21) Application number: 25200731.5
(22) Date of filing: 08.09.2025
(51) Int. Cl.: H10P 72/00, H10P 72/50, H10P 72/76, H10H 29/02, H10P 72/70

(54) **LIGHT EMITTING ELEMENT TRANSFER SYSTEM AND METHOD THEREOF**

(30) Priority: 13.09.2024 KR 20240125559
(71) Applicant: Samsung Display Co., Ltd., Yongin-si, Gyeonggi-do 17113 (KR)
(72) Inventor: RYU, Han Chun, Yongin-si (KR)
(74) Representative: Marks & Clerk LLP

(57) **Abstract**

A light emitting element transfer device includes a vacuum chamber for creating or removing a vacuum atmosphere inside, an alignment stage disposed inside the vacuum chamber and movable in three axes, a bonding stage disposed inside the vacuum chamber and movable up and down, a portable chuck having a built-in heater and selectively connectable with the alignment stage and the bonding stage and a chuck holder coupled with the portable chuck and movable between the alignment stage and the bonding stage inside the vacuum chamber, where the portable chuck is engaged with the chuck holder to chuck a first substrate on a top surface of the portable chuck and is detached from the chuck holder to de-chucking the first substrate from the top surface.

## Description

### BACKGROUND

### 1. Field

The present disclosure relates to a light emitting element transfer device and a transfer method.

### 2. Description of the Related Art

The importance of display devices is increasing along with the development of multimedia. In response to this, various types of display devices such as organic light emitting display devices (OLED) and liquid crystal display devices (LCD), etc. are being used.

A display panel such as a light emitting display panel or a liquid crystal display panel is included as a device that displays an image of a display device. Among them, the light emitting display panel may include a light emitting diode (LED), and as a light emitting diode, an organic light emitting diode that uses an organic substance as a fluorescent material or an inorganic light emitting diode that uses an inorganic substance as a fluorescent material is included.

When manufacturing a display panel that uses an inorganic light emitting diode as a light emitting diode, transfer equipment for transferring micro LED devices onto the substrate of the display panel must be developed.

### SUMMARY

Aspects and features of embodiments of the present disclosure are to provide a light emitting element transfer device capable of performing an accurate alignment process and a bonding process in the same chamber.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an embodiment, a light emitting element transfer device includes a vacuum chamber for creating or removing a vacuum atmosphere inside, an alignment stage disposed inside the vacuum chamber and movable in three axes, a bonding stage disposed inside the vacuum chamber and movable up and down, a portable chuck having a built-in heater and selectively connectable with the alignment stage and the bonding stage, and a chuck holder coupled with the portable chuck and movable between the alignment stage and the bonding stage inside the vacuum chamber, where the portable chuck is engaged with the chuck holder to chuck a first substrate on a top surface of the portable chuck and is detached from the chuck holder to de-chucking the first substrate from the top surface.

The portable chuck may further include a male coupler for engaging with the alignment stage and the bonding stage.

The male coupler may include an insertion portion formed such that a portion of a built-in fastening member therein protrudes outward, and the alignment stage and the bonding stage may each have a groove-shaped female coupler formed at a position corresponding to the male coupler on a top surface thereof and engaged with the male coupler.

The male coupler may be an air clamp, and the female coupler may be a locator ring corresponding to the air clamp.

The first transfer head has a cavity having an opening facing downward, and the width of the opening is smaller than the width of the cavity.

The portable chuck may include a bonding protrusion, the chuck holder may define a bonding groove into which the bonding protrusion is inserted and engaged, and the bonding protrusion and the bonding groove may be electrically connected by engagement.

The chuck holder may support at least a portion of a side surface of the portable chuck such that the top surface of the portable chuck is exposed.

The device may further include an upper chuck to which a second substrate disposed with light emitting elements is attached, and the upper chuck may be disposed to overlap with the alignment stage in a plan view.

The upper chuck may chuck the second substrate and is movable up and down.

The device may further include a vision member for photographing positions of the first substrate and the second substrate.

The device may further include a pressure member, which is disposed on the bonding stage, pressurizes the first substrate bonded to the second substrate disposed on the bonding stage, and transmits laser light; and a laser member, which emit the laser light from above the pressure member to the first substrate bonded to the second substrate disposed on the bonding stage.

The chuck holder may turn the portable chuck upside down.

The vacuum chamber may include a chamber door located on one side of the vacuum chamber, and the first substrate or the second substrate may enter and exit the vacuum chamber through the chamber door.

According to an embodiment, a method for transferring a light emitting element includes: disposing a first substrate on a top surface of a chuck holder; engaging the chuck holder with a portable chuck such that the portable chuck chucks the first substrate; aligning the first substrate disposed on the portable chuck with a second substrate chucked by an upper chuck by an alignment stage engaged with the portable chuck; separating the second substrate from the upper chuck to bond the first substrate and the second substrate; separating the portable chuck from the alignment stage; transferring, by the chuck holder, the portable chuck onto a bonding stage to engage the portable chuck and the bonding stage; and performing a bonding process of the first substrate to the second substrate.

The engaging of the chuck holder with the portable chuck may include: inserting a bonding protrusion of the portable chuck into a bonding groove of the chuck holder such that the portable chuck and the chuck holder are coupled with each other, and the bonding protrusion and the bonding groove may be electrically connected such that an electrostatic force is generated in the portable chuck to chuck the first substrate.

In the separating of the second substrate from the upper chuck, the upper chuck may stop adsorbing or holding the second substrate.

The method may further include photographing, by a vision member, positions of the first substrate and the second substrate.

In the separating of the portable chuck from the alignment stage, the portable chuck may be separated from the alignment stage by separating a male coupler of the portable chuck from a female coupler of the alignment stage.

The transferring of the portable chuck onto the bonding stage may include moving the chuck holder along a transfer rail onto the bonding stage while being coupled with the portable chuck, and bring the portable chuck close to the bonding stage such that the male coupler of the portable chuck is coupled with a female coupler of the bonding stage.

The performing of the bonding process may include: pressing, by a pressure member, the first substrate bonded to the second substrate disposed on the portable chuck, and applying electricity to a heater built into the portable chuck to heat the heater and to conduct heat to the portable chuck such that the heat is transferred to the first substrate or a joint between the first substrate and the second substrate.

According to one embodiment of the disclosure, the light emitting element transfer device may continuously perform the alignment process and the bonding process in a high vacuum environment without opening the vacuum chamber, thereby increasing the production efficiency of the transfer device.

In addition, since the alignment process and the bonding process may be performed in a high vacuum environment, the penetration of moisture or oxygen into the light emitting element of the target substrate may be minimized. Therefore, the reliability of the element of the target substrate, i.e., the display device, may be effectively improved.

However, the effects of the present disclosure are not limited to the aforementioned effects, and various other effects are included in the present specification.

At least some of the above and other features of the invention are set out in the claims.

### BRIEF DESCRIPTION OF THE DRAWINGS

FIG. 1 is a layout diagram illustrating a display device according to one embodiment.
FIG. 2 is an diagram illustrating an example of a pixel of FIG. 1.
FIG. 3 is an diagram illustrating another example of a pixel of FIG. 1.
FIG. 4 is a cross-sectional view illustrating an example of a display panel cut along line A-A' of FIG. 2.
FIG. 5 is a schematic plan view of a light emitting element transfer device according to an embodiment.
FIG. 6 is a schematic side view of a light emitting element transfer device according to an embodiment.
FIGS. 7 and 8 are enlarged views of a portable chuck, a chuck holder, and an alignment stage according to the embodiments of FIGS. 5 and FIG. 6.
FIGS. 9 and 10 are enlarged views of a portable chuck, a chuck holder, and a bonding stage according to the embodiments of FIGS. 5 and FIG. 6.
FIG. 11 is a view illustrating an inverted state of a portable chuck according to another embodiment.
FIG. 12 is a flow chart to illustrate a light emitting element transfer method using a transfer device according to one embodiment.
FIGS. 13 to 21 are schematic views of a transfer device to illustrate a light emitting element transfer method according to one embodiment.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above (i.e., view in a third direction DR3 that is a thickness direction of the substrate SUB), and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments of the present disclosure will be described in detail with reference to the accompanying drawings.

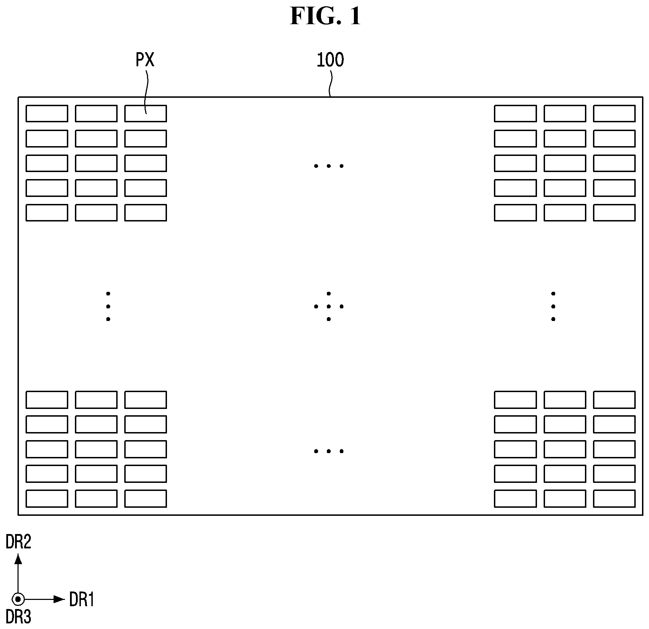

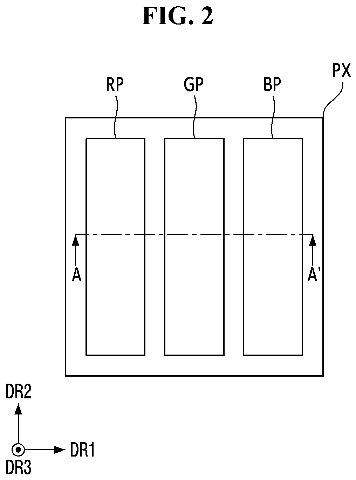

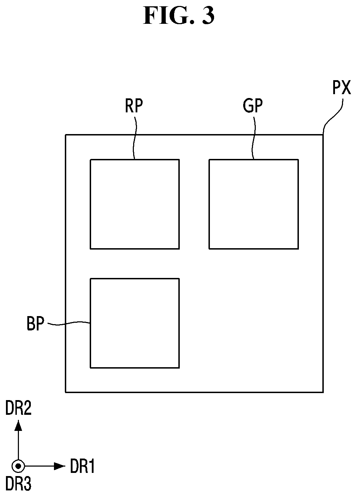

FIG. 1 is a layout diagram illustrating a display device according to one embodiment. FIG. 2 is an diagram illustrating an example of a pixel of FIG. 1. FIG. 3 is an diagram illustrating another example of a pixel of FIG. 1.

Referring to FIGS. 1 to 3, a display device 100 is a device for displaying video or still images, such as mobile phones, smart phones, tablet personal computers , and portable electronic devices such as smart watches, watch phones, mobile communication terminals, electronic notebooks, e-books, portable electronic devices such as portable multimedia players (PMP), navigation, and ultra mobile PCs (UMPC), as well as display screens for a variety of products such as televisions, laptops, monitors, billboards, and the internet of things (IOT).

The display device 100 may be formed as a rectangular plane having a long side in a first direction DR1 and a short side in a second direction DR2 intersecting the first direction DR1. A corner where the long side in the first direction DR1 and the short side in the second direction DR2 meet may be formed rounded to have a predetermined curvature or formed at a right angle. The planar shape of the display device 100 is not limited to a rectangle, and may be formed in other polygonal, circular, or oval shapes. The display device 100 may be formed flat but is not limited thereto. For another example, the display device 100 is formed at left and right ends and may include curved portions with a constant curvature or a changing curvature. Additionally, the display device 100 may be formed to be flexible, such as to be able to be bent, curved, bent, folded, or rolled.

The display device 100 may further include pixels PX for displaying an image, scan lines extending in the first direction DR1, and data lines extending in the second direction DR2. The pixels PX may be disposed in a matrix form in the first direction DR1 and the second direction DR2.

Each of the pixels PX may include a plurality of sub-pixels RP, GP, and BP as shown in FIGS. 2 and 3. In FIGS. 2 and 3, each of the pixels PX includes three sub-pixels RP, GP, and BP, that is, a first sub-pixel RP, a second sub-pixel GP, and a third sub-pixel BP, but the embodiment of the present disclosure is not limited thereto.

The first sub-pixel RP, the second sub-pixel GP, and the third sub-pixel BP may be connected to one of the data lines and at least one scan line among the scan lines.

Each of the first sub-pixel RP, the second sub-pixel GP, and the third sub-pixel BP may have a planar shape of a rectangle, a square, or a rhombus. For example, each of the first sub-pixel RP, the second sub-pixel GP, and the third sub-pixel BP may have a planar shape of a rectangle having a short side in the first direction DR1 and a long side in the second direction DR2, as shown in FIG. 2. Alternatively, each of first sub-pixel RP, the second sub-pixel GP, and the third sub-pixel BP may have a planar shape of a square or a rhombus including sides having the same length in the first direction DR1 and the second direction DR2, as shown in FIG. 3.

As shown in FIG. 2, the first sub-pixel RP, the second sub-pixel GP, and the third sub-pixel BP may be disposed in the first direction DR1. Alternatively, one of the second sub-pixel GP and the third sub-pixel BP and the first sub-pixel RP may be disposed in the first direction DR1, and the other one and the first sub-pixel RP may be disposed in the second direction DR2. For example, as shown in FIG. 3, the first sub-pixel RP and the second sub-pixel GP may be disposed in the first direction DR1, and the first sub-pixel RP and the third sub-pixel BP may be disposed in the second direction DR2.

Alternatively, one of the first sub-pixel RP and the third sub-pixel BP and the second sub-pixel GP may be disposed in the first direction DR1, and the other one and the second sub-pixel GP may be disposed in the second direction DR2. Alternatively, one of the first sub-pixel RP and the second sub-pixel GP and the third sub-pixel BP may be disposed in the first direction DR1, and the remaining one and the third sub-pixel BP may be disposed in the second direction DR2.

The first sub-pixel RP may include a first light emitting element that emits first light, the second sub-pixel GP may include a second light emitting element that emits second light, and the third sub-pixel BP may include a third light emitting element that emits third light. Here, the first light may be light in a red wavelength band, the second light may be light in a green wavelength band, and the third light may be light in a blue wavelength band. The red wavelength band may be a wavelength band of about 600 nanometers (nm) to 750 nm, the green wavelength band may be a wavelength band of about 480 nm to 560 nm, and the blue wavelength band may be a wavelength band of about 370 nm to 460 nm, but the embodiments of the present disclosure are not limited thereto.

Each of the first sub-pixel RP, the second sub-pixel GP, and the third sub-pixel BP may include an inorganic light emitting element having an inorganic semiconductor as a light emitting element that emits light. For example, the inorganic light emitting element may be a micro LED (Light Emitting Diode) of a flip-chip type, but the embodiment of the present disclosure is not limited thereto.

As shown in FIGS. 2 and 3, the area of the first sub-pixel RP, the area of the second sub-pixel GP, and the area of the third sub-pixel BP may be substantially the same, but the embodiment of the present disclosure is not limited thereto. At least one of area of the first sub-pixel RP, the area of the second sub-pixel GP, and the area of the third sub-pixel BP may be different from another one. Alternatively, any two of the area of area of the first sub-pixel RP, the area of the second sub-pixel GP, and the area of the third sub-pixel BP may be substantially the same, and the remaining one may be different from the two. Alternatively, the area of the first sub-pixel RP, the area of the second sub-pixel GP, and the area of the third sub-pixel BP may be different from each other.

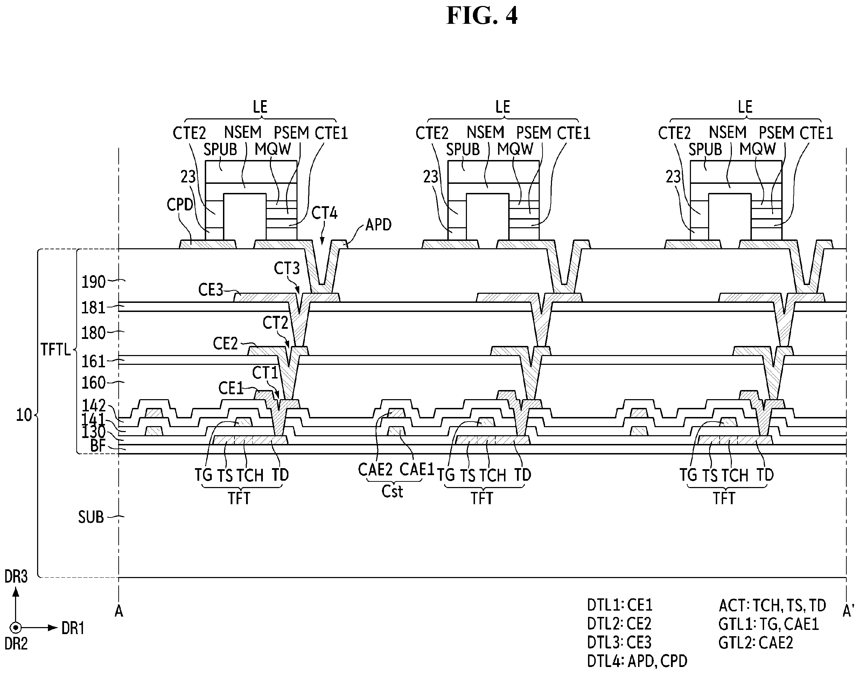

FIG. 4 is a cross-sectional view illustrating an example of a display panel cut along line A-A' of FIG. 2.

Referring to FIG. 4, the display device 100 may include a thin film transistor layer TFTL and light emitting elements LE disposed on a substrate SUB. The thin film transistor layer TFTL may be a layer on which thin film transistors TFT are formed.

The thin film transistor layer TFTL may include an active layer ACT, a first gate layer GTL1, a second gate layer GTL2, a first data metal layer DTL1, a second data metal layer DTL2, a third data metal layer DTL3, and a fourth data metal layer DTL4. Further, the thin film transistor layer TFTL includes a buffer film BF, a gate insulating film 130, a first interlayer insulating film 141, a second interlayer insulating film 142, a first planarization film 160, a first insulating film 161, a second planarization film 180, and a second insulating film 181.

The substrate SUB may be a base substrate or a base member for supporting a display device. The substrate SUB may be a rigid substrate made of glass, but the embodiments of the present disclosure are not limited thereto. The substrate SUB may be a flexible substrate capable of bending, folding, rolling, etc. In this case, the substrate SUB may include an insulating material such as a polymer resin such as polyimide (PI).

A buffer film BF may be disposed on one surface of the substrate SUB. The buffer film BF may be a film for preventing the penetration of air or moisture. The buffer film BF may be formed of a plurality of inorganic films alternately laminated. For example, the buffer film BF may be formed as a multilayer of alternately stacked inorganic films of one or more of a silicon nitride layer, a silicon oxynitride layer, a silicon oxide layer, a titanium oxide layer, and an aluminum oxide layer. The buffer film BF may be omitted.

An active layer ACT may be disposed on the buffer film BF. The active layer ACT may include a silicon semiconductor, such as polycrystalline silicon, monocrystalline silicon, low-temperature polycrystalline silicon, and amorphous silicon, or may comprise an oxide semiconductor.

The active layer ACT may include a channel TCH, a first electrode TS, and a second electrode TD of a thin film transistor TFT. The channel TCH of the thin film transistor TFT may be an area overlapping with a gate electrode TG of the thin film transistor TFT in the third direction DR3 that is a thickness direction of the substrate SUB. The first electrode TS of the thin film transistor TFT may be disposed on one side of the channel TCH, and the second electrode TD may be disposed on the other side of the channel TCH. The first electrode TS and the second electrode TD of the thin film transistor TFT may be areas that do not overlap with the gate electrode TG in the third direction DR3. The first electrode TS and the second electrode TD of the thin film transistor TFT may be areas in which ions are doped in a silicon semiconductor or an oxide semiconductor to have conductivity.

A gate insulating film 130 may be disposed on the active layer ACT. The gate insulating film 130 may be formed of an inorganic film, such as a silicon nitride layer, a silicon oxynitride layer, a silicon oxide layer, a titanium oxide layer, or an aluminum oxide layer.

A first gate layer GTL1 may be disposed on the gate insulating film 130. The first gate layer GTL1 may include the gate electrode TG of the thin film transistor TFT and the capacitor electrode Cst. The first gate layer GTL1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first interlayer insulating film 141 may be disposed on the first gate layer GTL1. The first interlayer insulating film 141 may be formed of an inorganic film, such as a silicon nitride layer, a silicon oxynitride layer, a silicon oxide layer, a titanium oxide layer, or an aluminum oxide layer.

A second gate layer GTL2 may be disposed on the first interlayer insulating film 141. The second gate layer GTL2 may include a second capacitor electrode CAE2 of the capacitor Cst. The second gate layer GTL2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second interlayer insulating film 142 may be disposed on the second gate layer GTL2. The second interlayer insulating film 142 may be formed of an inorganic film, such as a silicon nitride layer, a silicon oxynitride layer, a silicon oxide layer, a titanium oxide layer, or an aluminum oxide layer.

A first data metal layer DTL1 including a first connection electrode CE1, a first sub-pad, and a data line may be disposed on the second interlayer insulating film 142. The data line may be formed integrally with the first sub-pad, but the embodiment of the present disclosure is not limited thereto. The first data metal layer DTL1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first connection electrode CE1 may be connected to the first electrode TS or the second electrode TD of the thin film transistor TFT through the first contact hole CT1 penetrating the first interlayer insulating film 141 and the second interlayer insulating film 142.

A first planarization film 160 may be disposed on the first data metal layer DTL1 to planarize the step caused by the active layer ACT, the first gate layer GTL1, the second gate layer GTL2, and the first data metal layer DTL1. The first planarization film 160 may be formed from an organic film such as an acrylic resin, an epoxy resin, a phenolic resin, a polyamide resin, a polyimide resin, or the like.

A second data metal layer DTL2 may be disposed on the first planarization film 160. The second data metal layer DTL2 may include a second connection electrode CE2 and a second sub-pad. The second connection electrode CE2 may be connected to the first connection electrode CE1 through a second contact hole CT2 penetrating the first insulating film 161 and the first planarization film 160. The second data metal layer DTL2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second planarization film 180 may be disposed on the second data metal layer DTL2. The second planarization film 180 may be formed of an organic film, such as an acrylic resin, an epoxy resin, a phenolic resin, a polyamide resin, a polyimide resin, or the like.

A third data metal layer DTL3 may be disposed on the second planarization film 180. The third data metal layer DTL3 may include a third connection electrode CE3 and a third sub pad. The third connection electrode CE3 may be connected to the second connection electrode CE2 through a third contact hole CT3 penetrating the second insulating film 181 and the second planarization film 180. The third data metal layer DTL3 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A third planarization film 190 may be disposed on the third data metal layer DTL3. The third planarization film 190 may be formed of an organic film, such as an acrylic resin, an epoxy resin, a phenolic resin, a polyamide resin, a polyimide resin, or the like.

A fourth data metal layer DTL4 may be disposed on the third planarization film 190. The fourth data metal layer DTL4 may include an anode pad electrode APD, a cathode pad electrode CPD, and a fourth sub pad. The anode pad electrode APD may be connected to a third connection electrode CE3 through a fourth contact hole CT4 penetrating the third insulating film 191 and the third planarization film 190. The cathode pad electrode CPD may be supplied with a first power supply voltage that is a low potential voltage. The fourth data metal layer DTL4 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The light emitting element LE is exemplified as a flip-chip type micro LED in which the first contact electrode CTE1 and the second contact electrode CTE2 are disposed to face the anode pad electrode APD and the cathode pad electrode CPD but is not limited thereto. The light emitting element LE may be an inorganic light emitting element made of an inorganic material such as GaN. The light emitting element LE may have a length in the first direction DR1, a length in the second direction DR2, and a length in the third direction DR3 of several to several hundred micrometers (µm), respectively. For example, the light emitting element LE may have a length in the first direction DR1, a length in the second direction DR2, and a length in the third direction DR3 of approximately 100 µm or less, respectively.

The light emitting elements LE may be grown and formed on a semiconductor substrate such as a silicon wafer. Each of the light emitting elements LE may be transferred directly from the silicon wafer onto the anode pad electrode APD and the cathode pad electrode CPD of the substrate SUB. In this case, the first contact electrode CTE1 and the anode pad electrode APD may be bonded to each other through a bonding process. Further, the second contact electrode CTE2 and the cathode pad electrode CPD may be bonded to each other through the bonding process. The first contact electrode CTE1 and the anode pad electrode APD may be electrically connected to each other through a bonding electrode 23. Furthermore, the second contact electrode CTE2 and the cathode pad electrode CPD may be electrically connected to each other through the bonding electrode 23.

In one example, the bonding electrode 23 may be disposed on one side of the light emitting element LE. The bonding electrode 23 may be a bonding product of pressurized melting bonding using a laser. Here, the pressurized melting bonding refers to a state in which the bonding electrode 23 is heated and melted, and the light emitting element LE, the anode pad electrode APD, and the cathode pad electrode CPD are melted and mixed, and then cooled and solidified when the laser supply is terminated. Since the conductivity of the light emitting element LE, the anode pad electrode APD, and the cathode pad electrode CPD is maintained while being cooled and solidified in a melted and mixed state, the anode pad electrode APD, the cathode pad electrode CPD, and the light emitting element LE may be electrically connected and physically connected, respectively. Accordingly, the bonding electrode 23 may be disposed on the first contact electrode CTE1 and the second contact electrode CTE2 of the light emitting element LE.

The bonding electrode 23 may include, for example, Au, AuSn, PdIn, InSn, NiSn, Au-Au, AgIn, AgSn, Al, Ag, or carbon nanotubes CNT. Each of these may be used alone or in combination of two or more.

Each of the light emitting elements LE may be a light emitting structure including a base substrate SPUB, an n-type semiconductor NSEM, an active layer MQW, a p-type semiconductor PSEM, a first contact electrode CTE1, and a second contact electrode CTE2.

The base substrate SPUB may be a sapphire substrate, but the embodiments of the present disclosure are not limited thereto.

The n-type semiconductor NSEM may be disposed on one surface of the base substrate SPUB. For example, the n-type semiconductor NSEM may be disposed on a bottom surface of the base substrate SPUB. The n-type semiconductor NSEM may be made of GaN doped with n-type conductive dopants such as Si, Ge, Sn, and the like.

The active layer MQW may be disposed on a portion of one surface of the n-type semiconductor NSEM. The active layer MQW may include a material having a single or multiple quantum well structure. When the active layer MQW includes a material having a multi-quantum well structure, it may have a structure in which multiple well layers and barrier layers are alternately laminated. In this case, the well layers may be formed of InGaN, and the barrier layers may be formed of GaN or AlGaN but are not limited thereto. Alternatively, the active layer MQW may have a structure in which semiconductor materials having a large band gap energy and semiconductor materials having a small band gap energy are alternately laminated and may include different group III to group V semiconductor materials depending on the wavelength of the light emitted.

In one embodiment of the present disclosure, a flip-chip type light emitting element has been described as an example, but it is not limited thereto, and a vertical type light emitting element may be used in another embodiment.

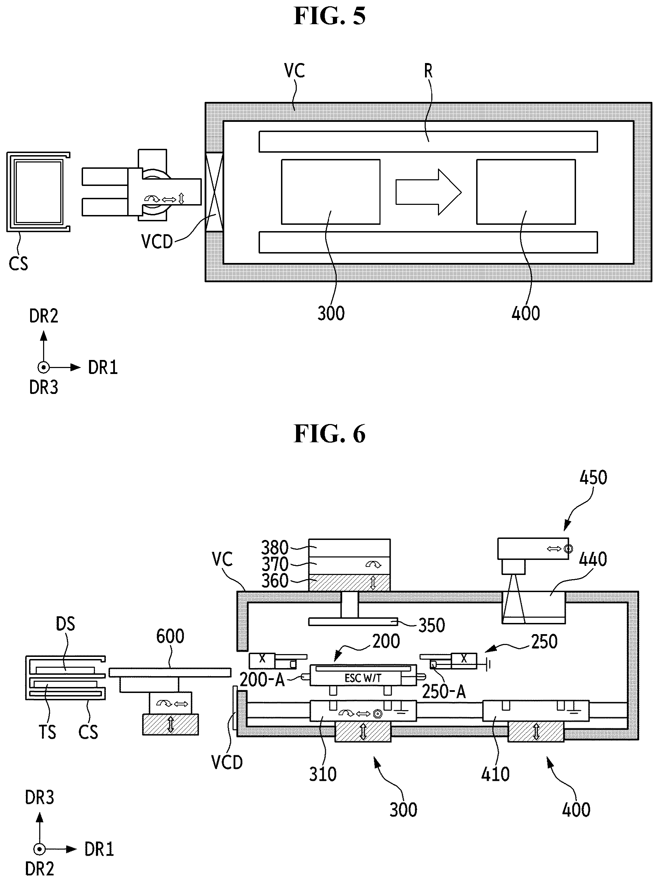

FIG. 5 is a schematic plan view of a light emitting element transfer device according to one embodiment. FIG. 6 is a schematic side view of a light emitting element transfer device according to one embodiment.

Referring to FIGS. 5 and 6, a light emitting element transfer device according to one embodiment may align and bond a first substrate TS and a second substrate DS on which light emitting elements are disposed, thereby bonding the light emitting elements to the second substrate DS.

The first substrate TS described in this specification is a processing target of the light emitting element transfer device and is a substrate on which light emitting elements are transferred. The first substrate TS in the following description will be described mainly based on the case where it is a substrate of an inorganic light emitting display device as shown in FIG. 4.

The second substrate DS is a processing target of the light emitting element transfer device and is a substrate on which light emitting elements are disposed, and provides light emitting elements to the first substrate TS.

Specifically, the light emitting element transfer device may include a vacuum chamber VC, and a portable chuck 200, a chuck holder 250, an alignment portion 300, and a bonding portion 400 disposed within the vacuum chamber VC.

The vacuum chamber VC provides an internal process space where manufacturing processes such as alignment, lamination, bonding, laser irradiation, and movement are performed. The vacuum chamber VC provides a process space for vacuum, heating, soundproofing, cooling, vibration-free, and waterproofing, etc., and may further include a vacuum device, an air suction device, a purification device, a heating device, a cooling device, and the like.

For example, the vacuum chamber VC may be maintained in a vacuum state by a vacuum device including a vacuum pump and a vacuum valve. For example, the vacuum chamber VC may include a gate valve and a door VCD. The gate valve and the door VCD may be disposed on one side of the vacuum chamber VC. The gate valve may be disposed on one side of the vacuum chamber VC. The first substrate TS and the second substrate DS may be supplied into the vacuum chamber VC through the gate valve. That is, the gate valve may provide a path through which the first substrate TS and the second substrate DS may enter and exit. The vacuum chamber VC may break the vacuum atmosphere when the bonding process is completed.

The portable chuck 200, the chuck holder 250, the alignment portion 300, and the bonding portion 400 may be disposed inside the vacuum chamber VC. A portion of the alignment portion 300, and the bonding portion 400 may be disposed outside the vacuum chamber VC, but the alignment process and the bonding process are performed in the same vacuum atmosphere inside one vacuum chamber VC. Therefore, problems such as air being trapped between the first substrate TS and the second substrate DS during the alignment process and the bonding process, thereby lowering the alignment degree or interfering with the transmission of the pressurizing force, do not occur.

The portable chuck 200 is disposed inside the vacuum chamber VC and may be selectively combined with the alignment stage 310 and the bonding stage 410. The portable chuck 200 is coupled with the chuck holder 250 and may move between the alignment portion 300, and the bonding portion 400. For example, the chuck holder 250 may move along a transfer rail R disposed in the vacuum chamber VC.

The first substrate TS, lifted by a transfer device such as a robot arm, may be loaded onto the portable chuck 200.

One side of the portable chuck 200 may have a wider area than one side of the first substrate TS. One side of the portable chuck 200 may cover the entire first substrate TS. For example, a diameter of the first substrate TS may be about 300 nm, and a diameter of the portable chuck 200 may be about 350 nm to 650 nm but is not limited thereto.

The portable chuck 200 is a chucking device that fixes a first substrate TS on one side, and may be, for example, an electrostatic chuck. The electrostatic chuck is attached to the first substrate TS by the force of static electricity. When a '+' or '-' are applied to the electrostatic chuck, the object is charged with an opposite potential '-' or '+', and the first substrate TS is attached to the electrostatic chuck and fixed by utilizing the principle that the charged potential generates a force that attracts each other.

The portable chuck 200 is equipped with a built-in heater 200-h. The built-in heater 200-h is configured to generate heat, for example, by an electric heater. The heater conducts heat through the portable chuck 200 and heats the first substrate TS supported on the portable chuck 200. By controlling the amount of heat generated by the heater, the temperature of the first substrate TS or its bonding surface may be adjusted.

The chuck holder 250 supports the portable chuck 200 so that a top surface of the portable chuck 200 is exposed. For example, the chuck holder 250 may support/hold a side surface (e.g., opposite ends or edges) of the portable chuck 200. Alternatively, the chuck holder 250 may define an opening in the center thereof.

The chuck holder 250 and the portable chuck 200 are configured to be coupled.

For example, the chuck holder 250 defines a bonding groove 250-A, and the portable chuck 200 has a bonding protrusions 200-A. The bonding protrusion 200-A may be inserted into the bonding groove 250-A and joined to each other. The bonding protrusion 200-A may be electrically connected when the bonding groove 250-A is joined. The bonding protrusion 200-A and the bonding groove 250-A may include a conductive material. However, the invention is not limited thereto and the chuck holder 250 may include a bonding protrusion and the portable chuck 200 may include a bonding groove.

Electricity may be supplied to the portable chuck 200 by applying electricity to the chuck holder 250. Therefore, when the chuck holder 250 and the portable chuck 200 are joined, the chuck function of the portable chuck 200 is activated, and the portable chuck 200 can be chuck the first substrate TS. On the other hand, when the chuck holder 250 and the portable chuck 200 are detached, the chuck function is deactivated, so that the portable chuck 200 may de-chuck the first substrate TS.

The portable chuck 200 may include a male coupler 200-C at a lower portion. The male coupler 200-C may be bonded with the alignment stage 310 and the bonding stage 410.

Since the portable chuck 200 may move from the alignment stage 310 to the bonding stage 410 while supporting the first substrate TS bonded with the second substrate DS, when the first substrate TS bonded with the second substrate DS is moved as it is, deflection may occur in the central portion of the first substrate TS bonded with the second substrate DS. This deflection increases in conjunction with the increase in size of the first substrate TS bonded to the second substrate DS. This deflection may cause the alignment of the first substrate TS bonded to the second substrate DS to become unaligned. To prevent this, a carrier is sometimes used to raise the first substrate TS bonded to the second substrate DS on the carrier. In this case, the carrier may be deformed and flattened due to heat during the bonding process. This makes it difficult to reuse the carrier. Furthermore, the alignment of the first substrate TS bonded to the second substrate DS may become unaligned due to the deformed carrier.

The alignment portion 300 is a device for aligning and bonding the first substrate TS and the second substrate DS and may include an alignment stage 310, an upper chuck 350, and a vision member 380. Also, the alignment portion 300 may further include a lifting member 360 and a driving member 370 for driving the upper chuck 350. For this purpose, the first substrate TS and the second substrate DS may include alignment marks.

The upper chuck 350 may be disposed on the ceiling of the vacuum chamber VC and overlaps the alignment stage 310. The upper chuck 350 absorbs or grips the back surface of the second substrate DS to support the second substrate DS above the first substrate TS during the alignment process. The upper chuck 350 may include a holding mechanism such as a vacuum absorption method, a mechanical chuck, or an electrostatic chuck. For example, the upper chuck 350 may be an electrostatic chuck but is not limited thereto.

The alignment stage 310 may be a high-precision stage, also called a UVW stage, as an alignment stage. The UVW stage may control the position in the three directions of the U-axis, V-axis, and W-axis. The UVW stage includes linear motors installed in each of the U-axis, V-axis, and W-axis directions, and may precisely control the position by individually controlling each linear motor. In one embodiment, a UVW stage that controls the position in the three directions of the U-axis, V-axis, and W-axis is presented, but the UVW stage is a concept that includes an alignment stage that may control the desired position by installing linear motors in each of the required position control directions, such as the XYθ direction and the XY direction.

The linear motor is a form in which a general rotary motor is cut in the axial direction, and directly generates linear motion force by the attractive and repulsive forces between the electromagnetic field of the mover and the permanent magnets (N/S poles) that constitute the stator. The linear motor has the advantage of being less noisy and less worn than a conventional ball screw and is capable of precise movement.

In this way, the alignment stage 310 has high precision for position alignment. However, the UVW stage may not be able to withstand a high pressing force compared to a general stage. Therefore, the bonding process is performed on a separate bonding stage 410 instead of performing a bonding process with high pressure added on the UVW stage.

The top surface of the alignment stage 310 is plate-shaped and may be engaged with the portable chuck 200 as described above.

The portable chuck 200 may engage with the alignment stage 310, so that the first substrate TS supported on the top surface of the portable chuck 200 and the second substrate DS becomes attached to the upper chuck 350 and may be precisely aligned. Once the alignment is completed, the upper chuck 350 may separate the second substrate DS and attach the second substrate DS to the first substrate TS.

The lifting member 360 may be disposed on the upper chuck 350 and may raise and lower the upper chuck 350. The lifting member 360 may include a lifting and lowering cylinder or the like.

The driving member 370 is disposed on the top side of the lifting member 360 and may move or rotate the upper chuck 350 up, down, left, and right on a plane.

The vision member 380 may recognize alignment markers disposed on the first substrate TS and the second substrate DS. For example, the vision member 380 may include at least one camera module. The vision member 380, the lifting member 360, and the driving member 370 are shown disposed outside the vacuum chamber VC but are not limited thereto. For another example, the vision member 380 may be disposed inside the vacuum chamber VC.

The bonding portion 400 may apply heat and pressure to the first substrate TS and the second substrate DS that are transferred in a bonded state by the first transfer portion 500 and irradiates a laser to transfer the light emitting elements disposed on the second substrate DS to the first substrate TS.

The bonding portion 400 may include a bonding stage 410, a pressure member 440, and a laser member 450.

The bonding stage 410 may be bonded to a portable chuck 200 and support the portable chuck 200 during the bonding process. The bonding stage 410 may move up and down. The bonding stage 410 may include a driving member including a lifting and lowering cylinder, etc. The bonding stage 410 may withstand greater pressure than the alignment stage 310.

The portable chuck 200 when disposed on the bonding stage 410 can generate heat through the built-in heater 200-h to heat the first substrate TS.

The pressure member 440 may be disposed on the ceiling of the vacuum chamber VC and may overlap the bonding stage 410. The pressure member 440 can pressurize the first substrate TS and the second substrate DS sequentially disposed on the portable chuck 200.

At least a portion of the pressure member 440 may be made of a transparent material. Accordingly, light emitted from the laser member 450 may penetrate the transparent material of the pressure member 440.

Preferably, a glass or ceramic material is used as the transparent material. The transparent material is desirable not be transparent to the naked eye but is desirable to only consist of a material through which the light emitted by the light source is transmitted.

The laser member 450 may include a drive system that is movable up, down, left, and right on one side. The laser member 450 may be disposed on top of the pressure member 440 to irradiate the first substrate TS and the second substrate DS with laser light.

The laser member 450 may be configured in various forms, such as a form that continuously irradiates a specific area or a form that scans.

The transfer member 600 may be a robot or the like and may load the first substrate TS or the second substrate DS loaded in the cassette CS disposed outside the vacuum chamber VC onto the portable chuck 200 within the vacuum chamber VC or unload the first substrate TS bonded to the second substrate DS within the vacuum chamber VC.

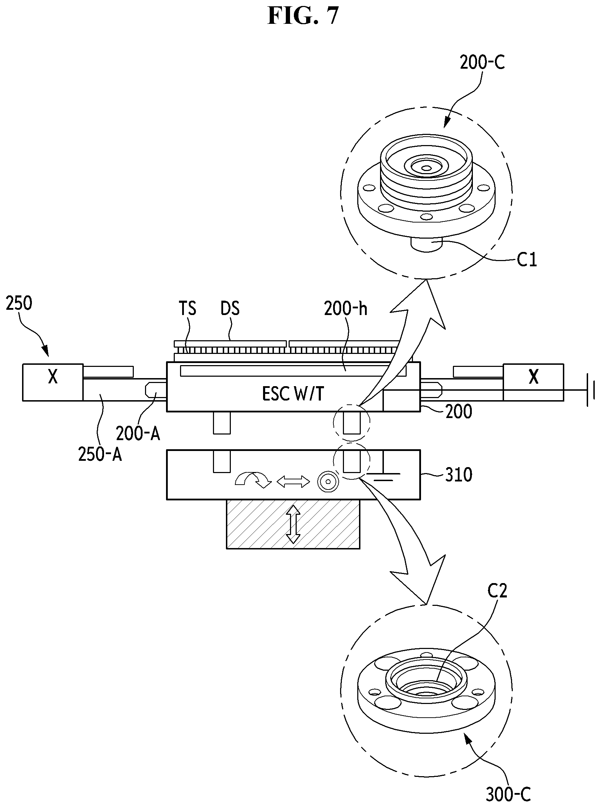

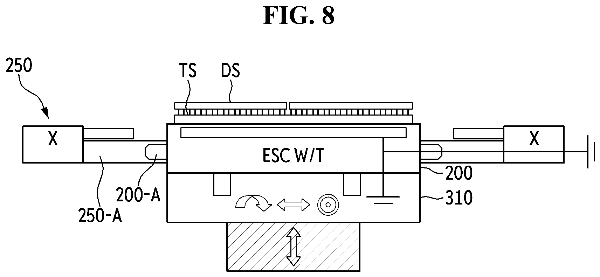

FIGS. 7 and 8 are enlarged views of a portable chuck, a chuck holder, and an alignment stage according to the embodiments of FIGS. 5 and FIG. 6. FIG. 7 is a drawing to illustrate a state in which the portable chuck 200 and the alignment stage 310 are separated, and FIG. 8 is a drawing to illustrate a state in which the portable chuck 200 and the alignment stage 310 are combined.

Referring to FIG. 7, the portable chuck 200 is shown coupled with the chuck holder 250. Therefore, the portable chuck 200 is engaged with the chuck holder 250 and receives electricity to chuck the first substrate TS.

The portable chuck 200 may be coupled with the alignment stage 310.

The portable chuck 200 may include a male coupler 200-C for engagement, and the alignment stage 310 may include a female coupler 300-C, but is not limited thereto, and the portable chuck 200 may include a female coupler 300-C, and the alignment stage 310 may include a male coupler 200-C in another embodiment.

In one embodiment, the male coupler 200-C may be an air clamp, and the female coupler 300-C may be a locator ring. Accordingly, one of the male coupler 200-C and the female coupler 300-C is formed to be supplied with air and may transition to a clamp state in which they are coupled and fixed to each other depending on whether air is supplied. The following assumptions are for convenience of description only, and the present disclosure is not limited thereto.

In one embodiment, a fastening member may be formed in an air clamp corresponding to the male coupler 200-C, and a fastening groove may be defined in a locator ring corresponding to the female coupler 300-C.

When a fastening member is formed in the male coupler 200-C, an air path may be formed in the male coupler 200-C so that the male coupler 200-C may be supplied with air. Accordingly, each male coupler 200-C may be connected to the pneumatic control portion through the air path. Therefore, an air pressure of a certain level or higher may be applied to the male coupler 200-C according to the air supplied from the pneumatic control portion.

When the male coupler 200-C is formed on the portable chuck 200, an air path connected to the male coupler 200-C may be formed at a point of the portable chuck 200 corresponding to the male coupler 200-C.

Meanwhile, when the male coupler 200-C is formed on the portable chuck 200, the female coupler 300-C may be formed at a position corresponding to each male coupler 200-C on the alignment stage 310 coupled with the portable chuck 200. When the portable chuck 200 and the alignment stage 310 come closer to each other, the insertion portion C1 of each male coupler 200-C formed on each portable chuck 200 may be inserted into the insertion groove C2 of each female coupler 300-C defined on the alignment stage 310 according to the movement.

When the air supplied to the male coupler 200-C along the air path is blocked and the applied air pressure is lowered below a certain level, the male coupler 200-C, i.e. the blocking member which prevents the outward protrusion of the fastening member embedded in the insertion portion C1 of the air clamp, may be moved by the elastic force of the elastic body connected to the blocking member. Then, according to the movement of the position of the blocking member, the fastening member may be moved to a position corresponding to a through-hole defined in the insertion portion C1, and a portion of the fastening member may be protruded to the outside through the through-hole.

Then, as described above, when the insertion portion C1 of the male coupler 200-C is inserted into the insertion groove C2 of the female coupler 300-C, i.e., the locator ring, the insertion portion C1 and the insertion groove C2 may be coupled to each other while the portion of the fastening member protruding outwardly is caught in the fastening groove formed in the insertion groove C2, thereby bringing the male coupler 200-C and the female coupler 300-C into a clamped state in which the male coupler 200-C and the female coupler 300-C are coupled and fixed.

When air is applied to the male coupler 200-C again along the air path, and the air pressure applied to the male coupler 200-C increases again to a certain level or higher, the blocking member built into the insertion portion C1 of the male coupler 200-C may move to the original position according to the applied air pressure. Then, the blocking member may push the fastening member. Therefore, the fastening member may move inward. Since the fastening member is then completely embedded into the inside of the male coupler 200-C, the fastening due to the engagement with the fastening groove is released, and the coupling between the insertion portion C1 and the insertion groove C2 may be released. In other words, the clamp state in which the male coupler 200-C and the female coupler 300-C are coupled and fixed may be released.

In this way, the air clamp uses the characteristic of transitioning to the clamp state or releasing the clamp state when air supplied from the pneumatic control portion is supplied or the air supply is cut off, so that in one embodiment, the portable chuck 200 and the alignment stage 310 may be coupled and fixed, or the coupling state between the coupled portable chuck 200 and the alignment stage 310 may be released.

As such, a separate pneumatic control portion may be provided for coupling and fixing the portable chuck 200 and the alignment stage 310 or releasing the coupling state between the coupled stage and the base.

FIG. 8 illustrates a state in which the first substrate TS is chucked, and the insertion portion C1 of the air clamp, which is the male coupler 200-C of the portable chuck 200, is inserted into the insertion groove C2 of the locator ring, which is the female coupler 300-C of the alignment stage 310, and the clamp state is changed, so that the portable chuck 200 and the alignment stage 310 may be coupled.

Accordingly, the portable chuck 200 and the first substrate TS on the portable chuck 200 may also move in the same manner according to the movement for alignment of the alignment stage 310.

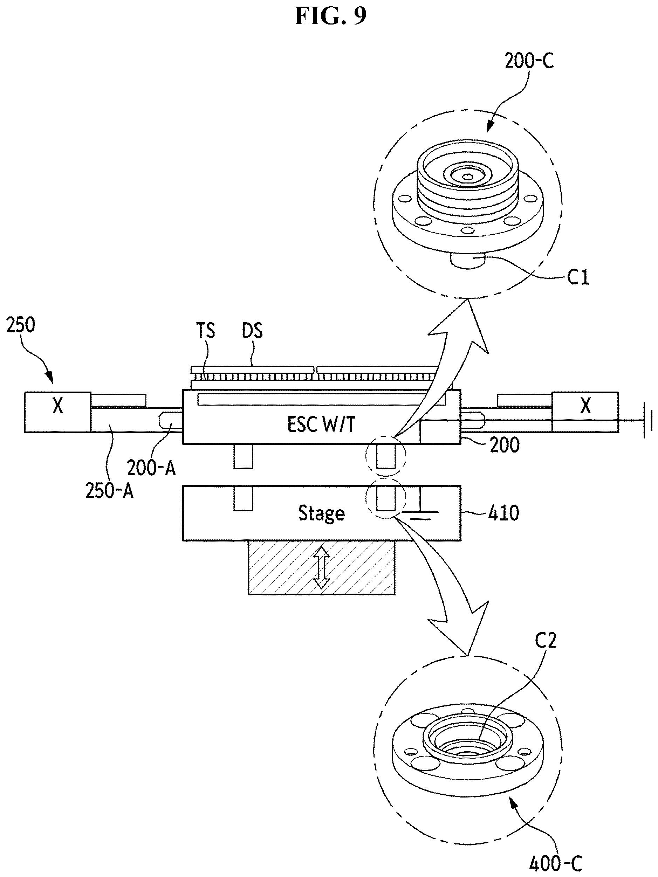

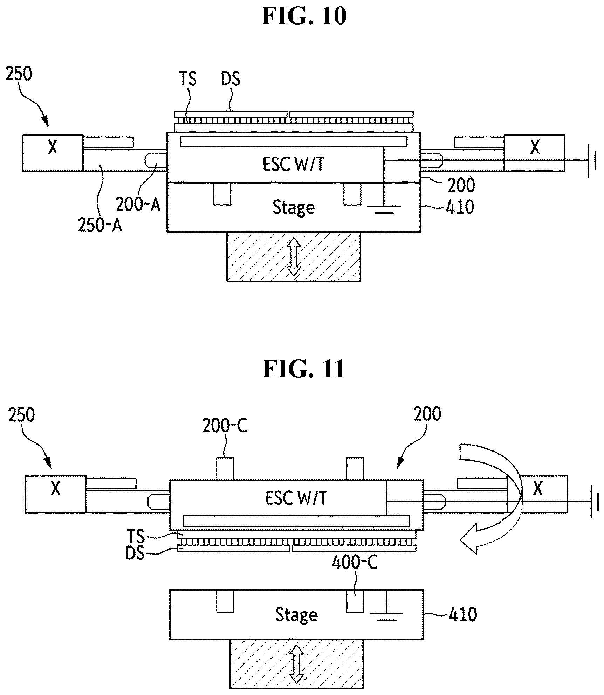

FIGS. 9 and 10 are enlarged views of a portable chuck, a chuck holder, and a bonding stage according to the embodiments of FIGS. 5 and FIG. 6. FIG. 9 is a drawing to illustrate a state in which the portable chuck 200 and the bonding stage 410 are separated, and FIG. 10 is a drawing to illustrate a state in which the portable chuck 200 and the bonding stage 410 are combined.

Referring to FIGS. 9 and 10, the portable chuck 200 is coupled with the chuck holder 250. Therefore, the portable chuck 200 is engaged with the chuck holder 250 and receives electricity to chuck the first substrate TS.

The portable chuck 200 may be engaged with the bonding stage 410.

The portable chuck 200 may include a male coupler 200-C for engagement, and the bonding stage 410 may include a female coupler 400-C but is not limited thereto. The portable chuck 200 may include a female coupler 400-C, and the bonding stage 410 may include a male coupler 200-C in another embodiment.

In one embodiment, the male coupler 200-C may be an air clamp, and the female coupler 400-C may be a locator ring. Accordingly, either the male coupler 200-C or the female coupler 400-C may be formed to be supplied with air, and may transition to a clamp state in which they are coupled and fixed to each other depending on whether air is supplied. The following assumptions are for convenience of description only, and the present disclosure is not limited thereto.

In one embodiment, a fastening member may be formed in an air clamp corresponding to the male coupler 200-C, and a fastening groove may be formed in a locator ring corresponding to the female coupler 400-C.

When the male coupler 200-C is formed in the portable chuck 200, the female coupler 400-C may be formed at a position corresponding to each male coupler 200-C in a bonding stage 410 coupled with the portable chuck 200. when the portable chuck 200 and the bonding stage 410 come closer to each other, the insertion portion C1 of each male coupler 200-C formed on each portable chuck 200 may be inserted into the insertion groove C2 of each female coupler 400-C formed on the bonding stage 410 according to the movement.

As described with reference to FIGS. 7 and 8, the air clamp may be switched to a clamp state or released from a clamp state when air supplied from a pneumatic control portion is supplied or when the air supply is cut off, thereby using the characteristic that the portable chuck 200 and the bonding stage 410 may be coupled and fixed, or the coupled portable chuck 200 and the bonding stage 410 may be released.

In this way, a pneumatic control portion may be separately provided for coupling and fixing the portable chuck 200 and the bonding stage 410 or releasing the coupled state between the coupled stage and the base.

FIG. 10 illustrates a state in which the first substrate TS is chucked, and the insertion portion C1 of the air clamp, which is a male coupler 200-C of the portable chuck 200, is inserted into the insertion groove C2 of the locator ring, which is a female coupler 400-C of the bonding stage 410, and transitions to a clamp state, so that the portable chuck 200 and the bonding stage 410 may be coupled.

The bonding stage 410 may support the first substrate TS bonded to the second substrate DS while a pressure is applied to the first substrate TS bonded to the second substrate DS disposed on the portable chuck 200 during the bonding process.

FIG. 11 is a view illustrating an inverted state of a portable chuck according to another embodiment.

Referring to FIG. 11, the portable chuck 200 may be combined with the chuck holder 250 as described above to chuck the first substrate TS (or the first substrate TS bonded to the second substrate DS) disposed on one side.

The chuck holder 250 may invert/turn the portable chuck 200 upside down. In one embodiment, the portable chuck 200 may be inverted so that the front side (i.e., top surface) of the portable chuck 200 faces downward, and the back side (i.e., bottom surface) of the portable chuck 200 faces upward.

In this way, even if the portable chuck 200 is inverted due to the chucking state of the portable chuck 200, the first substrate TS may be fixed to one side (i.e., the front side) of the portable chuck 200.

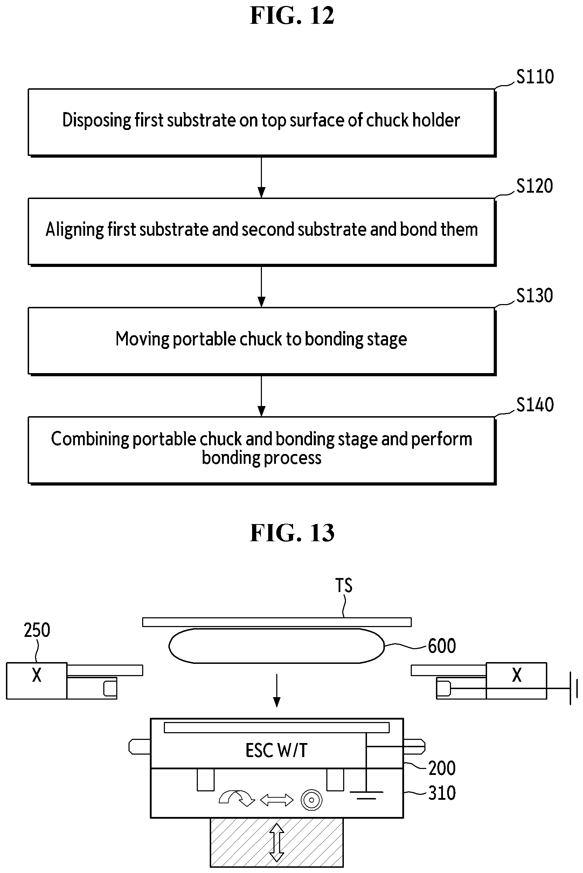

FIG. 12 is a flow chart to illustrate a light emitting element transfer method using a transfer device according to one embodiment. FIGS. 13 to 21 are schematic views of a transfer device to illustrate a light emitting element transfer method according to one embodiment. FIGS. 13 to 20 may be transfer devices with reference to FIGS. 5 to 10.

First, the first substrate TS is disposed on the top surface of the chuck holder 250. (S110 in FIG. 12)

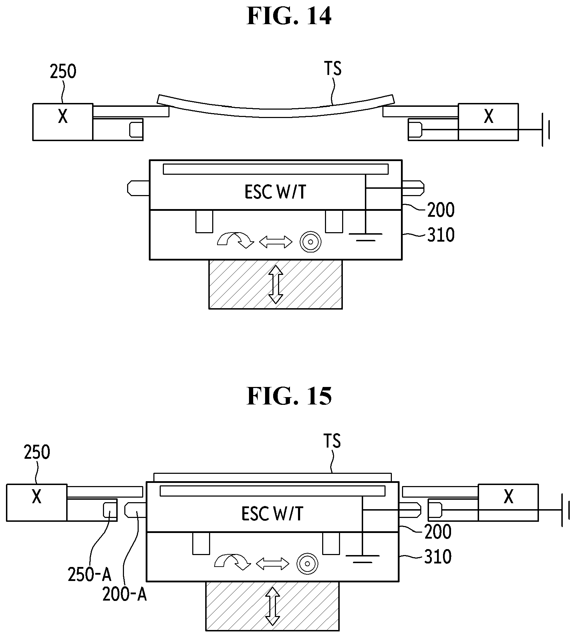

Referring to FIG. 13 and 14, a first substrate TS is disposed on the chuck holder 250 by a transfer member 600 such as a robot. The chuck holder 250 supports at least a portion of the edge of the first substrate TS. When the chuck holder 250 supports at least a portion of the edge of the first substrate TS, the center of the first substrate TS may be bent downward by its own weight.

Referring to FIG. 15, a first substrate TS is disposed on the top surface of the portable chuck 200. The portable chuck 200 is connected to the alignment stage 310.

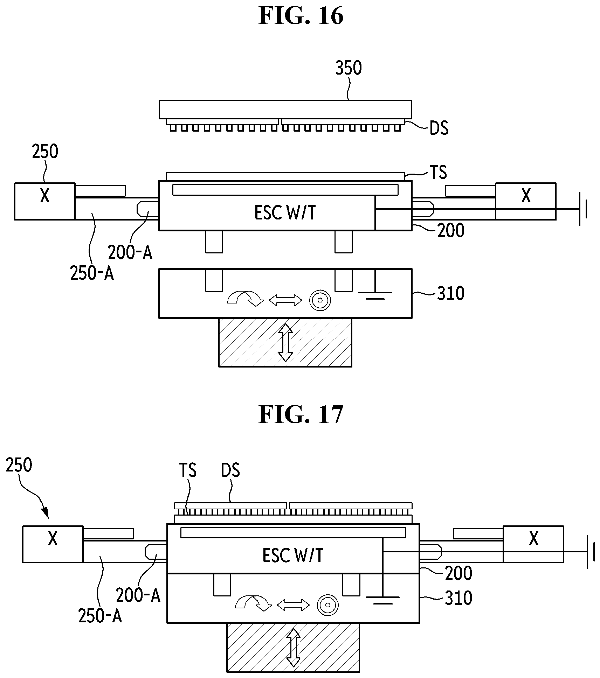

Referring to FIG. 16, the portable chuck 200 and the chuck holder 250 are combined. The bonding groove 250-A of the chuck holder 250 and the bonding protrusion 200-A of the portable chuck 200 may be coupled to each other. As a result, the portable chuck 200 may chuck the first substrate TS.

Second, the first substrate TS and the second substrate DS are aligned and bonded together. (S120 in FIG. 12)

Referring to FIG. 16, the first substrate TS and the second substrate DS are aligned and bonded. For example, the upper chuck 350 fixes the back surface of the second substrate DS. The light emitting element disposed on the second substrate DS may be disposed to face the first substrate TS.

The alignment mark of the first substrate TS and the second substrate DS is checked with the vision member (380 in FIG. 6), and the alignment stage 310 is moved based on the alignment mark to align the first substrate TS and the second substrate DS.

Thereafter, referring to FIG. 17, the first substrate TS and the second substrate DS are bonded together, and the upper chuck 350 is de-chucking to release the fixation of the second substrate DS, thereby separating the second substrate DS from the upper chuck 350.

Third, the portable chuck 200 is moved to the bonding stage 410. (S130 in FIG. 12)

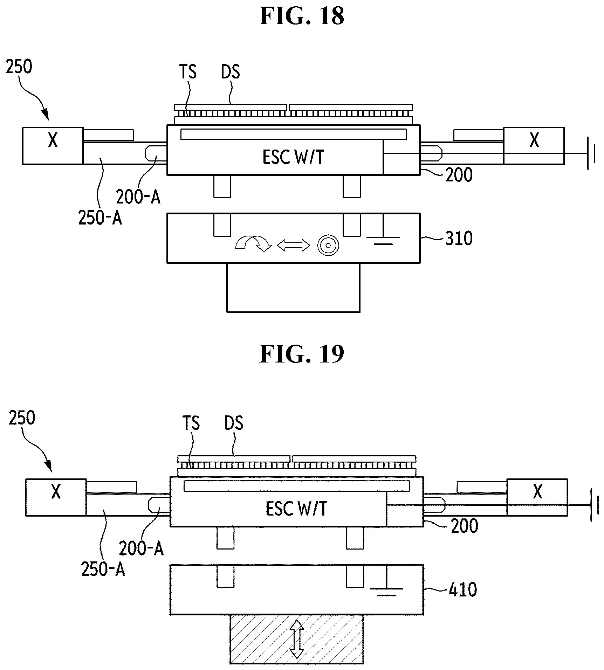

For example, referring to FIG. 18, the portable chuck 200 releases the engagement state of the alignment stage 310 and the air clamp, and is separated from each other. The portable chuck 200 continues to be coupled to the chuck holder 250. In this way, the portable chuck 200 may maintain the state of fixing the first substrate TS.

Referring to FIG. 19, the portable chuck 200 moves along the transfer rail while fixing the first substrate TS onto the bonding stage 410 within the same chamber.

Fourth, the portable chuck 200 and the bonding stage 410 are coupled, and a bonding process is performed. (S140 in FIG. 12)

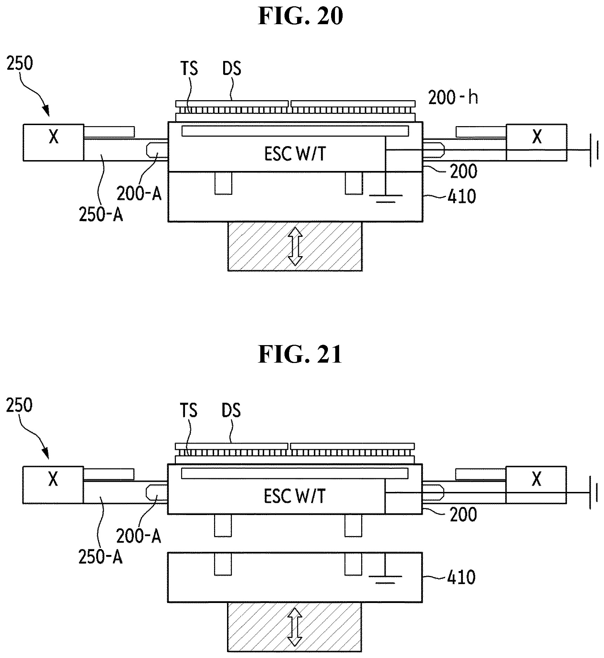

Referring to FIG. 20, when the portable chuck 200 is positioned close to the top surface of the bonding stage 410, the male coupler 200-C of the portable chuck 200 may be bonded to the female coupler 400-C of the bonding stage 410.

Thereafter, the bonding process may be performed. For example, the pressure member 440 may pressurize the first substrate TS and the second substrate DS sequentially disposed on the portable chuck 200.

Electricity may be applied to the built-in heater 200-h embedded into the portable chuck 200 to heat the built-in heater 200-h, thereby conducting heat to the portable chuck 200, thereby transferring heat to the first substrate TS or the joint between the first substrate TS and the second substrate DS.

In an embodiment, the laser member 450 may irradiate a laser to the boundary between the first substrate TS or the second substrate DS and the first substrate TS bonded to the second substrate DS on top of the pressure member 440. The laser beam emitted from the laser member 450 may be transmitted through the pressure member 440 to be irradiated to the first substrate TS bonded to the second substrate DS or to the boundary between the second substrate DS and the first substrate TS.

The laser member 450 may be implemented in various laser irradiation methods, such as a method of continuously irradiating a specific area or a method of scanning.

Referring to FIG. 20, during the bonding process, the bonding stage 410 may fixedly support the portable chuck 200.

Afterwards, when the bonding process is completed, the portable chuck 200 is released from the bonding stage 410, and the vacuum chamber VC may release the vacuum.

The first substrate TS bonded to the second substrate DS may be transported while being disposed on the portable chuck 200. Therefore, the portable chuck 200 may also function as a carrier or tray.

Although embodiments of the present disclosure have been described above with reference to the attached drawings, a person skilled in the art to which the present disclosure pertains will understand that the present disclosure may be implemented in other specific forms without changing its technical idea or essential features. Therefore, the embodiments described above should be understood in all respects as illustrative and not restrictive. Embodiments are set out in the following clauses:
Clause 1. A light emitting element transfer device comprising, a vacuum chamber for creating or removing a vacuum atmosphere inside; an alignment stage disposed inside the vacuum chamber and movable in three axes; a bonding stage disposed inside the vacuum chamber and movable up and down; a portable chuck having a built-in heater and selectively connectable with the alignment stage and the bonding stage; and a chuck holder coupled with the portable chuck and movable between the alignment stage and the bonding stage inside the vacuum chamber, wherein the portable chuck is engaged with the chuck holder to chuck a first substrate on a top surface of the portable chuck and is detached from the chuck holder to de-chucking the first substrate from the top surface.
Clause 2. The device of clause 1, wherein the portable chuck further includes a male coupler for engaging with the alignment stage and the bonding stage.
Clause 3. The device of clause 2, wherein the male coupler includes an insertion portion formed such that a portion of a built-in fastening member therein protrudes outward,
   wherein the alignment stage and the bonding stage each have a groove-shaped female coupler formed at a position corresponding to the male coupler on a top surface thereof and engaged with the male coupler.
Clause 4. The device of clause 3, wherein the male coupler is an air clamp,
   wherein the female coupler is a locator ring corresponding to the air clamp.
Clause 5. The device of any one of clauses 1 to **4,** wherein the first transfer head has a cavity having an opening facing downward, and the width of the opening is smaller than the width of the cavity.
Clause 6. The device of any one of clauses 1 to 5, wherein the portable chuck includes a bonding protrusion, wherein the chuck holder defines a bonding groove into which the bonding protrusion is inserted and engaged, wherein the bonding protrusion and the bonding groove are electrically connected by engagement.
Clause 7. The device of any one of clauses 1 to 6, wherein the chuck holder supports at least a portion of a side surface of the portable chuck such that the top surface of the portable chuck is exposed.
Clause 8. The device of any one of clauses 1, further comprising an upper chuck to which a second substrate disposed with light emitting elements is attached, and the upper chuck is disposed to overlap with the alignment stage in a plan view.
Clause 9. The device of clause 8, wherein the upper chuck chucks the second substrate and is movable up and down.
Clause 10. The device of clause 8 or 9, further comprising a vision member for photographing positions of the first substrate and the second substrate.
Clause 11. The device of any one of clauses 1, further comprising a pressure member, which is disposed on the bonding stage, pressurizes the first substrate bonded to the second substrate disposed on the bonding stage, and transmits laser light; and
   a laser member, which emits the laser light from above the pressure member to the first substrate bonded to the second substrate disposed on the bonding stage.
Clause 12. The device of any one of clauses 1, wherein the chuck holder turns the portable chuck upside down.
Clause 13. The device of any one of clauses 1, wherein the vacuum chamber includes a chamber door located on one side of the vacuum chamber,
   wherein the first substrate or the second substrate enters and exits the vacuum chamber through the chamber door.
Clause 14. A method for transferring a light emitting element comprising: disposing a first substrate on a top surface of a chuck holder; engaging the chuck holder with a portable chuck such that the portable chuck chucks the first substrate; aligning the first substrate disposed on the portable chuck with a second substrate chucked by an upper chuck by an alignment stage engaged with the portable chuck; separating the second substrate from the upper chuck to bond the first substrate and the second substrate; separating the portable chuck from the alignment stage; transferring, by the chuck holder, the portable chuck onto a bonding stage to engage the portable chuck and the bonding stage; and performing a bonding process of the first substrate to the second substrate.
Clause 15. The method of clause 14, wherein the engaging of the chuck holder with the portable chuck includes: inserting a bonding protrusion of the portable chuck into a bonding groove of the chuck holder such that the portable chuck and the chuck holder are coupled with each other, and wherein the bonding protrusion and the bonding groove are electrically connected such that an electrostatic force is generated in the portable chuck to chuck the first substrate.
Clause 16. The method of clause 14 or 15, wherein. in the separating of the second substrate from the upper chuck, the upper chuck stops adsorbing or holding the second substrate.
Clause 17. The method of clause 16, further comprising: photographing, by a vision member, positions of the first substrate and the second substrate.
Clause 18. The method of any one of clauses 14 to 17, wherein, in the separating of the portable chuck from the alignment stage, the portable chuck is separated from the alignment stage by separating a male coupler of the portable chuck from a female coupler of the alignment stage.
Clause 19. The method of clause 18, wherein the transferring of the portable chuck onto the bonding stage includes: moving the chuck holder along a transfer rail onto the bonding stage while being coupled with the portable chuck, and bring the portable chuck close to the bonding stage such that the male coupler of the portable chuck is coupled with a female coupler of the bonding stage.
Clause 20. The method of clause 19, wherein the performing of the bonding process includes: pressing, by a pressure member, the first substrate bonded to the second substrate disposed on the portable chuck, and applying electricity to a heater built into the portable chuck to heat the heater and to conduct heat to the portable chuck such that the heat is transferred to the first substrate or a joint between the first substrate and the second substrate.

## Claims

1. A light emitting element transfer device comprising:
a vacuum chamber (VC) for creating or removing a vacuum atmosphere inside;
an alignment stage (310) disposed inside the vacuum chamber (VC) and movable in three axes;
a bonding stage (410) disposed inside the vacuum chamber (VC) and movable up and down;
a portable chuck (200) having a built-in heater (200-h) and selectively connectable with the alignment stage (310) and the bonding stage (410); and
a chuck holder (250) configured to be coupled with the portable chuck (200) and movable between the alignment stage (310) and the bonding stage (410) inside the vacuum chamber (VC),
wherein the portable chuck (200) is configured to be engaged with the chuck holder (250) to chuck a first substrate (TS) on a top surface of the portable chuck (200) and to be detached from the chuck holder (250) to de-chuck the first substrate (TS) from the top surface.

2. The device of claim 1, wherein at least one of, the portable chuck (200), the alignment stage (310), and the bonding stage (410) includes a male coupler (200-C) for engaging the portable chuck (200) with the alignment stage (310) and/ or the bonding stage (410).

3. The device of claim 2, wherein the male coupler (200-C) includes an insertion portion (C1) formed such that a portion of a built-in fastening member therein protrudes outward.

4. The device of claim 2 or 3, wherein,
the alignment stage (310) and the bonding stage (410), each have a groove-shaped female coupler (300-C, 400-C) formed at a position corresponding to the male coupler (200-C) on a top surface thereof and configured to be engaged with the male coupler (200-C), or the portable chuck (200) has the groove-shaped female coupler (300-C, 400-C), optionally wherein the male coupler (200-C) is an air clamp, and the female coupler (300-C, 400-C) is a locator ring corresponding to the air clamp.

5. The device of any one of claims 1 to 4, wherein one of the portable chuck (200) and the check holder (250) includes a bonding protrusion (200-A),
wherein the other of the portable check and the chuck holder (250) defines a bonding groove (250-A) into which the bonding protrusion (200-A) is inserted and engaged,
wherein the bonding protrusion (200-A) and the bonding groove (250-A) are electrically connected by engagement.

6. The device of any one of claims 1 to 5, wherein the chuck holder (250) supports at least a portion of a side surface of the portable chuck (250) such that the top surface of the portable chuck (250) is exposed.

7. The device of any one of claims 1 to 6, further comprising an upper chuck (350) to which a second substrate (DS) disposed with light emitting elements is configured to be attached, and the upper chuck (350) is disposed to overlap with the alignment stage (310) in a plan view, optionally wherein the upper chuck (350) is configured to chuck the second substrate (DS) and is movable up and down, further optionally the device comprises a vision member (380) for photographing positions of the first substrate (TS) and the second substrate (DS).

8. The device of any one of claims 1 to 7, further comprising a pressure member (440), which is disposed on the bonding stage (410), is configured to pressurize the first substrate (TS) bonded to the second substrate (DS) disposed on the bonding stage (410), and to transmit laser light; and
a laser member (450), configured to emit laser light from above the pressure member (440) to a first substrate (TS) bonded to a second substrate (DS) disposed on the bonding stage (410).

9. The device of any one of claims 1 to 8, wherein the chuck holder (250) is configured to turn the portable chuck (200) upside down.

10. The device of any one of claims 1 to 9, wherein the vacuum chamber (VC) includes a chamber door (VCD) located on one side of the vacuum chamber (VC), wherein the chamber door (VCD) is configured to allow the first substrate (TS) or the second substrate (DS) to enter and exit the vacuum chamber (VC) through the chamber door.

11. A method for transferring a light emitting element comprising:
disposing a first substrate (TS) on a top surface of a chuck holder (250);
engaging the chuck holder (250) with a portable chuck (200) such that the portable chuck (200) chucks the first substrate (TS);
aligning the first substrate (TS) disposed on the portable chuck (200) with a second substrate (DS) chucked by an upper chuck (350) by an alignment stage (310) engaged with the portable chuck (200);
separating the second substrate (DS) from the upper chuck (350) to bond the first substrate (TS) and the second substrate (DS);
separating the portable chuck (200) from the alignment stage (310);
transferring, by the chuck holder (250), the portable chuck (200) onto a bonding stage (410) to engage the portable chuck (200) and the bonding stage (410); and
performing a bonding process of the first substrate (TS) to the second substrate (DS).

12. The method of claim 11, wherein the engaging of the chuck holder (250) with the portable chuck (200) includes:
inserting a bonding protrusion (200-A) of the portable chuck (200) into a bonding groove (250-A) of the chuck holder (250) such that the portable chuck (200) and the chuck holder (250) are coupled with each other, and
wherein the bonding protrusion (200-A) and the bonding groove (250-A) are electrically connected such that an electrostatic force is generated in the portable chuck (200) to chuck the first substrate (TS).

13. The method of claim 11 or 12, wherein in the separating of the second substrate (DS) from the upper chuck (350), the upper chuck (350) stops adsorbing or holding the second substrate (DS).

14. The method of claim 11, 12 or 13, further comprising: photographing, by a vision member (380), positions of the first substrate (TS) and the second substrate (DS).

15. The method of any one of claims 11 to 14, wherein, in the separating of the portable chuck (200) from the alignment stage (310),
the portable chuck (200) is separated from the alignment stage (310) by separating a male coupler (200-C) of the portable chuck (200) from a female coupler (300-C) of the alignment stage (310), optionally wherein the transferring of the portable chuck (200) onto the bonding stage (410) includes:
moving the chuck holder (250) along a transfer rail onto the bonding stage (410) while being coupled with the portable chuck (200), and
bring the portable chuck (200) close to the bonding stage (410) such that the male coupler (200-C) of the portable chuck (200) is coupled with a female coupler (400-C) of the bonding stage (410), further optionally wherein the performing of the bonding process includes:
pressing, by a pressure member (440), the first substrate (TS) bonded to the second substrate (DS) disposed on the portable chuck (200), and
applying electricity to a heater (200-h) built into the portable chuck (200) to heat the heater (200-h) and to conduct heat to the portable chuck (200) such that the heat is transferred to the first substrate (TS) or a joint between the first substrate (TS) and the second substrate (DS).
